# EUROPEAN PATENT APPLICATION

(11) **EP 2 346 085 A1**
(43) Date of publication of application: **20.07.2011**
(21) Application number: 09823701.9
(22) Date of filing: 30.10.2009
(51) Int. Cl.: H01L 31/04

(54) **SOLAR CELL**

(30) Priority: 31.10.2008 JP 2008281614; 27.02.2009 JP 2009046148
(71) Applicant: Asahi Glass Company Limited, Chiyoda-ku Tokyo 100-8405 (JP)
(72) Inventor: KUROKI Yuichi, Tokyo 100-8405 (JP); SHIRATORI Makoto, Haibara-gun Shizuoka 421-0302 (JP); WATANABE Toshinari, Tokyo 100-8405 (JP); MAEDA Kei, Tokyo 100-8405 (JP)
(74) Representative: Müller-Boré & Partner Patentanwälte
(86) International application number: PCT/JP2009/068687
(87) International publication number: WO 2010/050591

(57) **Abstract**

The present invention relates to a solar cell comprising a double tube composed of two glass tubes differing in the diameter and a photovoltaic conversion layer formed between the two glass tubes, the double tube being sealed at both ends of a part in which the photovoltaic conversion layer is formed, wherein at least one of the two glass tubes is composed of a glass comprising, in mass% based on the oxides, from 60 to 70% of SiO₂, from 4 to 10% of Al₂O₃, from 0 to 3% of B₂O₃, from 0 to 4% of MgO, from 2 to 9% of CnO, from 1 to 10% of SrO, from 0 to 2% of BaO, from 10 to 16% of Na₂O, from 0 to 5% of K₂O, from 0 to 2% of ZrO₂ and from 0 to 2% of CeO₂.

## Description

### Technical Field

The present invention relates to a solar cell in which a photovoltaic conversion layer is formed between glass tubes of a double glass tube, typically, a compound thin-film solar cell in which a photovoltaic conversion layer mainly composed of Group 11, 13 and 16 elements is formed on an inside glass tube (inner tube).

### Background Art

Group 11-13 and Group 11-16 compound semiconductors having a chalcopyrite crystal structure or cubic or hexagonal Group 12-16 compound semiconductors have a large absorption coefficient for light in the wavelength range from visible to near infrared, and therefore, they are expected as a material for high-efficiency thin-film solar cells. Representative examples thereof include a Cu(In,Ga)Se₂-based one (hereinafter referred to as CIGS-based one) and a CdTe-based one.

In the CIGS-based thin-film solar cell, a soda lime glass which is inexpensive and has a thermal expansion coefficient close to that of the CIGS-based compound semiconductor, has been studied as the substrate to obtain the solar cell.
Also, for obtaining high efficiency solar cells, a high heat resistance glass has been proposed (see, Patent Document 1).
In addition, a solar cell using a double glass tube has been also proposed (see, Patent Document 2). This solar cell is configured such that a CIGS-based thin film is formed on the outer side of an inner tube and protected by an outside glass tube (outer tube) and the end parts are air-tightly sealed. As for the glass tube of soda lime glass, there has been proposed, for example, glass for annular fluorescent lamps, which does not reduce the lighting efficiency and exhibits good thermal processing (see, Patent Document 3), but this is not necessarily optimal as a double glass tube for solar cells used outdoors.

### Related Art

### Patent Document

Patent Document 1: JP-A-11-135819
Patent Document 2: U.S. Patent Application Publication No. 2008/0110491, description
Patent Document 3: JP-B-63-16348

### Summary of the Invention

### Problems That the Invention Is To Solve

In the case of the above-described solar cell using a double glass tube, it may be considered to use a tube glass of a soda lime glass type (composition in mass%: 70% of SiO₂, 2% of Al₂O₃, 17% of Na₂O, 2% of K₂O, 3% of MgO, 6% of CaO) employed for fluorescent tubes, because this glass is inexpensive and has a thermal expansion coefficient close to that of the CIGS-based compound semiconductor. However, as described later, different characteristics are required of the inner tube and the outer tube, respectively, and the glass for fluorescent tubes can be hardly said to be optimal in terms of any of required characteristics.

An absorption layer of the CIGS-based solar cell is formed on the outer side of the inner tube, and the glass for the inner tube is required to withstand a high temperature, because, as disclosed in Patent Document 1, a heat treatment at a high temperature is preferred for preparing high efficiency solar cells. However, the glass composition having a relative high annealing point, which is proposed in Patent Document 1, is a material unsuited for forming of tube glass in view of its viscosity characteristics at high temperatures. On the other hand, the glass for annular fluorescent lamps, which is proposed in Patent Document 3, is a material incapable of withstanding the above-described heat treatment at a high temperature due to its too low softening point.

Meanwhile, in view of use for a solar cell, the glass composition must be a glass composition ensuring relatively high productivity and the high-temperature viscosity thereof is preferably low to a certain extent. That is, the annealing point or softening point is preferably high in comparison with the glass for fluorescent lamps, and the viscosity at high temperatures involving melting of glass is preferably not so much raised as compared with the glass for fluorescent tubes.

For the outer tube, first, from the standpoint of enhancing the efficiency of a solar cell, glass having a high transmittance over a wide range, particularly, even on the long wavelength side, is demanded. Furthermore, in view of long-term outdoor use, high weather resistance and insusceptibility to solarization are demanded. In the case of the conventional soda lime glass, depending on the content of Fe₂O₃, high transmittance may not be necessarily obtained on the long wavelength side, and the solarization resistance is also insufficient.

An object of the present invention is to provide a solar cell having a double glass tube structure capable of solving the problems faced when a glass tube composed of the conventional soda lime glass or the glass disclosed in Patent Document 1 is used as the glass of the double tube.

### Means for Solving the Problems

The present invention provides a solar cell in which a photovoltaic conversion layer is formed between two glass tubes of a double tube composed of two glass tubes differing in the diameter and the double tube is sealed at both ends of a part in which the photovoltaic conversion layer is formed, wherein at least one of the two glass tubes is composed of a glass comprising, in mass% based on the oxides, from 60 to 70% of SiO₂, from 4 to 10% of Al₂O₃, from 0 to 3% of B₂O₃, from 0 to 4% of MgO, from 2 to 9% of CaO, from 1 to 10% of SrO, from 0 to 2% of BaO, from 10 to 16% of Na₂O, from 0 to 5% of K₂O, from 0 to 2% of ZrO₂ and from 0 to 2% of CeO₂. Incidentally, for example, the phrase "comprises from 0 to 3% of B₂O₃" means that B₂O₃ is not essential but may be contained in an amount of up to 3%.

The present invention also provides a glass tube for a solar cell, which is used as at least one of two glass tubes of a solar cell where a photovoltaic conversion layer is formed between two glass tubes of a double tube composed of two glass tubes differing in the diameter and the double tube is sealed at both ends of a part in which the photovoltaic conversion layer is formed, and which is composed of a glass comprising, in mass% based on the oxides, from 60 to 70% of SiO₂, from 4 to 10% of Al₂O₃, from 0 to 3% of B₂O₃, from 0 to 4% of MgO, from 2 to 9% of CaO, from 1 to 10% of SrO, from 0 to 2% of BaO, from 10 to 16% of Na₂O, from 0 to 5% of K₂O, from 0 to 2% of ZrO₂ and from 0 to 2% of CeO₂.

### Advantage of the Invention

According to the present invention, the glass tube of a solar cell having a double glass tube structure can be made to satisfy the conditions that the annealing point or softening point is high in comparison with the soda lime glass-type tube glass employed for fluorescent lamps and the viscosity at high temperatures involving melting of glass is not so much raised as compared with the soda lime glass-type tube glass.
Also, the transmittance of the glass tube on the long wavelength side can be increased or the solarization resistance can be enhanced.

In the case of a CIGS-based photovoltaic conversion layer, the average linear expansion coefficient of the inner tube is preferably close to that of the CIGS-based semiconductor material, that is, preferably from 70×10⁻⁷ to 110× 10⁻⁷/°C, and according to the present invention, an average linear expansion coefficient near 90×10⁻⁷/°C can be obtained.

There is a method where in a solar cell having a double glass tube structure, the inner tube (a glass tube having a smaller diameter) and the outer tube (a glass tube having a larger diameter) are combined by designing different glass for respective tubes, but in view of efficiency of the production facility, it is preferred to develop a composition satisfying simultaneously all characteristics and constitute both the inner tube and the outer tube from one kind of a glass composition. This can be realized by the glass of the present invention.
In this case, when the glass is relatively difficult to clarify, use of a fining agent in combination may have to be considered, but depending on the combination, the solarization characteristics are seriously deteriorated. According to the preferred embodiment of the present invention ((1) the glass comprises CeO₂ and does not substantially comprise Sb₂O₃, or (2) the glass does not substantially comprise CeO₂ and comprises Sb₂O₃), good solarization characteristics can be obtained without causing such deterioration.

### Mode for Carrying Out the Invention

The solar cell of the present invention typically has the structure disclosed in Patent Document 2. That is, a back plate, a semiconductor junction and a photovoltaic conversion layer having a transparent conductive layer are formed on the outside surface of an inner tube, that is, on the surface opposing an outer tube, and the part between the inner tube and the outer tube, where the photovoltaic conversion layer is formed, is air-tightly sealed after removing oxygen and moisture by a vacuum treatment or the like. Incidentally, the photovoltaic conversion layer is typically a CIGS-based photovoltaic conversion layer.

The softening point of the glass of the inner tube or outer tube is preferably 705°C or more. If the softening point is less than 705°C, the process temperature, for example, when forming a CIGS film, cannot be so much elevated and a high efficiency CIGS film can be hardly formed. The softening point of the glass is more preferably 710°C or more, still more preferably 720°C or more.

The strain point of the glass of the inner tube or outer tube is preferably 490°C or more. If the strain point is less than 490°C, the process temperature when forming a CIGS film cannot be so much elevated and a high efficiency CIGS film can be hardly formed. The strain point of the glass is more preferably 495°C or more, still more preferably 500°C or more.

The temperature at which the viscosity of the glass of the inner tube or outer tube is 10² dPa·s is preferably 1,550°C or less. If this temperature exceeds 1,550°C, defects ascribable to high-temperature melting are increased and this causes a problem such as reduction in productivity or shortening of lifetime of the melting furnace. The temperature at which the viscosity is 10² dPa·s is more preferably 1,485°C or less, more preferably 1,465°C) or less.
Such glass preferred as the inner tube or outer tube can be formed into a tube by a known glass tubing method such as Danner method. That is, the forming of a glass tube is generally performed in the viscosity region of 10³ to 10⁶ dPa·s. Also, the viscosity of glass continuously changes with the temperature change and therefore, when the temperature giving 10² dPa·s becomes high, the forming temperature naturally rises. For example, in the Danner method, a refractory called sleeve is used and when the forming temperature rises, the corrosion speed of the refractory is increased and stable forming cannot be performed. When the temperature giving 10² dPa·s is 1,470°C or less, excessive rise of the forming temperature can be avoided.

The average linear expansion coefficient of glass of the inner tube or outer tube, particularly the inner tube, at 50 to 300°C is preferably from 70x 10⁻⁷ to 110×10⁻⁷/°C. If the average linear expansion coefficient is less than 70×10⁻⁷/°C or is more than 110× 10⁻⁷/°C. the thermal expansion difference from the CIGS film becomes too large and defects such as separation are readily produced. The average linear expansion coefficient is more preferably 75×10⁻⁷/°C or more or 100×10⁻⁷/°C or less.

The average transmittance of the glass of the inner tube or outer tube, particularly the outer tube, at a wavelength of 450 to 1,000 nm is preferably 90% or more in terms of thickness of 1 mm. If this average transmittance is less than 90%, the efficiency as a solar cell decreases. The average transmittance is more preferably 91 % or more.
The transmittance of the glass of the inner tube or outer tube, particularly the outer tube, at a wavelength of 400 nm is preferably 85% or more in terms of thickness of 1 mm. If this transmittance is less than 85%, the efficiency as a solar cell decreases. The transmittance is more preferably 86% or more and typically 88% or more.

In the glass of the inner tube or outer tube, particularly the outer tube, when a glass plate which has a thickness of 1 mm and is composed of that glass is irradiated with light of a high-pressure mercury lamp of 400 W for 300 hours from a distance from 15 cm, the decrease Δ₄₀₀ in the transmittance at a wavelength of 400 nm is preferably 4% or less. If the Δ₄₀₀ exceeds 4%, the glass may undergo solarization due to sunlight in a long-term use to decrease the efficiency of the solar cell. The Δ₄₀₀ is more preferably 3.5% or less.
In the glass of the inner tube or outer tube, particularly the outer tube, when it is held in a water vapor atmosphere at 120°C under 0.2 MPa for 20 hours, the amount of an alkali metal element deposited on the surface of the glass is preferably 180 nmol/cm² or less. If this amount exceeds 180 nmol/cm², the weather resistance is insufficient and long-term reliability in the solar cell application cannot be ensured. The amount is more preferably 150 nmol/cm² or less and is typically 120 nmol/cm² or less. Also, it is more preferred that the total amount ofNa and K is 180 nmol/cm² or less.

The reasons for limitation of the contents of the glass composition in the inner tube or outer tube are described below. In the following, unless otherwise indicated, mass% of components in the composition is simply referred to as "%".

SiO₂ is an essential component for glass formation and the content thereof is from 60 to 70%. If the content is less than 60%, the expansion coefficient becomes large or the chemical durability deteriorates. The content is preferably 61 % or more, more preferably 62% or more. Also, if the content is more than 70%, the expansion coefficient becomes small or the high-temperature viscosity (softening point) rises, making the tube formation difficult. The content is preferably 69% or less, more preferably 68% or less.

Al₂O₃ is a component for increasing the chemical durability and weather resistance and is an essential component. The content thereof is from 4 to 10%. If the content is less than 4%, the chemical durability and weather resistance deteriorate. The content is preferably 4.2% or more, more preferably 4.5% or more. If the content is more than 10%, the viscosity rises to cause inhomogeneous melting and the striae defect increases. The content is preferably 9% or less, more preferably 8% or less, still more preferably 7% or less.

B₂O₃ is not an essential component but may be contained in an amount of up to 3% for the purpose of, for example, enhancing the meltability. If the content is more than 3%, the softening point lowers or the expansion coefficient becomes small and this is not preferred for the process of forming a CIGS film. The content is preferably 2% or less, more preferably 1.5% or less.

MgO is not an essential component but may be contained in an amount of up to 4% for the purpose of, for example, enhancing the chemical durability. If the content is more than 4%, the glass is highly likely to be devitrified. The content is preferably 3.7% or less, more preferably 3% or less.

CaO is a component for lowering the high-temperature viscosity and the like, and is an essential component. The content thereof is from 2 to 9%. If the content is less than 2%, the high-temperature viscosity is not sufficiently lowered and the meltability is deteriorated. The content is preferably 3% or more, more preferably 4% or more. On the other hand, if the content is more than 9%, the glass is highly likely to be devitrified. The content is preferably 8% or less, more preferably 7.5% or less.

SrO is a component having an effect of, for example, lowering the high-temperature viscosity and improving the chemical durability and is an essential component. The content thereof is from 1 to 10%. If the content is less than 1%, the effect is small. The content is preferably 2% or more, more preferably 3% or more. If the content is more than 10%, the softening point lowers. The content is preferably 9% or less, more preferably 8% or less.

BaO is not an essential component but may be contained in an amount of up to 2% for the purpose of, for example, enhancing the chemical durability. If the content is more than 2%, bubble cutting in the melting process is not successfully achieved. The content is preferably 1.5% or less. Preferably, the total content of SrO and BaO is more than 4%, because the effect of lowering the high-temperature viscosity is distinctly observed. The total content is more preferably 5% or more.

Na₂O is a component for contributing to enhancement of the conversion efficiency of a CIGS-based solar cell and is an essential component The content thereof is from 10 to 16%. Na is known to diffuse into the absorption layer of a CIGS-based solar cell constructed on glass and enhance the conversion efficiency, but if the content is less than 10%, this gives rise to insufficient diffusion ofNa into the absorption layer of a CIGS-based solar cell on the glass and the conversion efficiency may also become insufficient. The content is preferably 10.5% or more, more preferably 11% or more, still more preferably 12% or more.
If the Na₂O content is more than 16%, the expansion coefficient becomes large or the chemical durability deteriorates. The content is preferably 15.5% or less, more preferably 15% or less, still more preferably 14% or less.

K₂O is not an essential component but may be contained in an amount of up to 5% for improving the meltability or adjusting the viscosity. If the content is more than 5%, the chemical durability may deteriorate. In the case where this component is contained, the content is preferably 4% or less.

ZrO₂ is not an essential component but may be contained in an amount of up to 2% for enhancing the heat resistance. If the content is more than 2%, the devitrification property may be deteriorated.

CeO₂ is not an essential component but may be contained as a fining agent in an amount of up to 2%. If the content is more than 2%, the transmittance in the short wavelength region is excessively decreased. In the case where CeO₂ is contained, the content thereof is preferably 0.2% or more. If the content is less than 0.2%, the component may not function as a fining agent. In the case where this component is contained, the content is more preferably 0.4% or more.
In the case where CeO₂ is contained, it is preferred that Sb₂O₃ is not substantially contained particularly in the glass of the outer tube. In this case, the content of Sb₂O₃ is typically less than 0.1% by outer percentage based on the total content of the glass components (exclusive of Fe₂O₃), because, if the glass comprises CeO₂ and at the same time, substantially comprises Sb₂O₃, the solarization characteristics may be deteriorated.
Incidentally, for fining the glass while maintaining the transmittance, it is preferred that Sb₂O₃ is contained and CeO₂ is not substantially contained. In this case, the content of Sb₂O₃ is preferably from 0.1 to 0.5% by outer percentage based on the total amount of the glass components (exclusive of Fe₂O₃). The content of CeO₂ here is typically less than 0.1% by outer percentage based on the total amount of the glass components.

At least one glass of the inner tube and the outer tube is essentially composed of the above-described components but may comprise other components typically in a total amount of 5% or less within the range not impairing the object of the present invention.
Depending on the case, ZnO, TiO₂, Li₂O, WO₃, Nb₂O₅, V₂O₅, Bi₂O₃, MoO₃, P₂O₅ and the like may be contained for the purpose of improving, for example, weather resistance, meltability, devitrification property and ultraviolet protection.

Incidentally, Fe₂O₃ is unavoidably contained as an impurity usually attributable to raw materials and the like, and the content thereof is typically 0.005% by outer percentage or more based on the total amount of the glass components (exclusive of Sb₂O₃ in the case where Sb₂O₃ is contained). However, if the content is more than 0.06%, the transmittance lowers and the efficiency of the solar cell decreases. For this reason, the content is preferably 0.06% or less. The content of Fe₂O₃ is more preferably 0.04% by outer percentage or less, still more preferably 0.03% by outer percentage or less, based on the total amount of the glass components (exclusive of Sb₂O₃ in the case where Sb₂O₃ is contained).

### Examples

Raw materials were mixed to obtain glass having a composition shown in percent by mass in the columns from SiO₂ to CeO₂ of Tables 1 to 3 and used as the glass raw material. In the Tables, as for two components of Sb₂O₃ and Fe₂O₃, the content by outer percentage based on the total of other components is shown.

The glass raw material in an amount giving a mass of 200 g after vitrification was put in a cylindrical bottomed platinum-rhodium crucible having a height of 90 mm and an outer diameter of 70 mm. The crucible was placed in a heating furnace and after heating at 1,600°C for 30 minutes while blowing air having a dew point of 80°C from the side of the heating furnace, the glass raw material inside the crucible was forcedly stirred with a stirrer for 30 minutes and thereby melted. Thereafter, stirring was stopped, and the melted glass in the crucible was left standing still for 30 minutes, followed by casting on a carbon plate and cooling in an annealing furnace. After cooling, the sample was taken out of the annealing furnace and subjected to the following measurements, readings or calculations. The results are shown in Tables 1 to 3. Here, Examples 1 to 13 are Examples of the present invention and Examples 14 to 17 are Comparative Examples.

The softening point Ts (unit: °C) and the strain point Sp (unit: °C) were measured in accordance with JIS R 3103.
The viscosity η of the melted glass was measured at 1,450°C, 1,500°C, 1,550°C, 1,600°C and 1,650°C by using a high-temperature rotational viscometer, and based on logη at each temperature, the temperature T2 (unit: °C) at which η is 10² dPa·s (the temperature at which logη is 2) was calculated.
The average linear expansion coefficient α (unit: 10⁻⁷/°C) at 50 to 300°C was measured using a differential thermal dilatometer (TMA).

Furthermore, both surfaces were mirror-polished to prepare a sample having a thickness of 1 mm for transmittance measurement. The transmittance at a wavelength of 400 to 1,000 nm was measured, and the transmittance T₄₀₀ (unit: %) at 400 nm was read. Also, the average transmittance T_{AV} (unit: %) at 450 to 1,000 nm was calculated.

In order to examine the solarization characteristics, the sample after the transmittance measurement was irradiated with UV light for 300 hours by locating a high-pressure mercury lamp of 400 W at a position 15 cm distant from the plate surface of the sample and then measured for the transmittance T'₄₀₀ (unit: %) at 400 nm.
The difference Δ₄₀₀ (unit: %) obtained by subtracting T'₄oo from T₄₀₀ is shown together in the Tables.

### Weather Resistance Test:

Both surfaces of a glass plate having a thickness of 1 to 2 mm and a size of 4 cm x 4 cm were mirror-polished with cerium oxide and cleaned using calcium carbonate and a neutral detergent, and then the glass plate was placed in a super accelerated life tester (Unsaturated Pressure Cooker EHS-411M, trade name, manufactured by Espec Corp.) and left standing still in a water vapor atmosphere at 120°C under 0.2 MPa for 20 hours. The sample after test and 20 ml of ultrapure water were put in a cleaned plastic bag with a zipper and after dissolving surface deposits by means of an ultrasonic wave cleaner for 10 minutes, the eluted alkali metal element was quantitatively determined by the ICP spectrometry. In this Example, elements except for Na and K were lower than the detection limit and therefore, the amount of an alkali metal element was measured as a total amount of Na and K. The elution amount was converted into mol and normalized with the surface area of the sample. In the Tables, the unit of numerical values is nmol/cm².

In Examples 1 to 13 which are Examples of the present invention, the glass has relatively low T2 while having α close to that of CIGS and exhibiting Sp of 490°C or more and can satisfy both high heat resistance near the CIGS process temperature and high productivity. Also, the transmittance at 400 nm and the transmittance at a wavelength of 400 nm after ultraviolet irradiation for 300 hours are sufficiently high and in turn, the solarization characteristics are sufficient.

On the other hand, in Example 14 which is Comparative Example, since Sp is less than 490°C, the process temperature when forming a CIGS film cannot be so much elevated, and a high efficiency CIGS film is difficult to form.
In Example 15 which is Comparative Example, the glass is glass for PDP substrate (see, Japanese Patent 3,731,281) and has high Sp but also has high T2, and high productivity as tube glass cannot be expected.
In Example 17 which is also Comparative Example, Sp is 481°C and is insufficient for the process temperature when forming a CIGS film and in addition, due to relatively high T2 of 1,471 °C, defects ascribable to high-temperature melting are increased, causing a problem such as reduction in productivity or shortening of lifetime of the melting furnace.
In Example 16 which is Comparative Example where CeO₂ and Sb₂O₃ are used in combination, the transmittance at a wavelength of 400 nm after ultraviolet irradiation for 300 hours is 84.4%, and the solarization characteristics are insufficient, which gives rise to decrease in the efficiency of a solar cell. Also, in Examples 14 and 17 which are Comparative Examples where the amount of Al₂O₃ is small, the weather resistance is bad, and long-term reliability in the solar cell application cannot be ensured.

**[Table 1]**

| | Example 1 | Example 2 | Example 3 | Example 4 | Example 5 | Example 6 | Example 7 |
|---|---|---|---|---|---|---|---|
| SiO₂ | 66.1 | 65.1 | 63.2 | 66.6 | 61,5 | 64.4 | 64.2 |
| Al₂O₃ | 4.8 | 4.8 | 4.8 | 4.8 | 4.7 | 5.7 | 5.7 |
| B₂O₃ | 1.1 | 1.1 | 1.1 | 1.1 | 1.1 | 1.1 | 1.1 |
| MgO | 0.6 | 2.6 | 2.5 | 0.6 | 2.5 | 2.8 | 3.2 |
| CaO | 7.1 | 4.9 | 4.8 | 7.1 | 4.8 | 5.3 | 4.9 |
| SrO | 4.4 | 6.4 | 6.6 | 4.4 | 8.8 | 5.6 | 6.1 |
| BaO | 0.9 | 0 | 0 | 0.9 | 0 | 0 | 0 |
| Na₂O | 13.0 | 13.1 | 13.1 | 13.7 | 10.9 | 13.1 | 13.1 |
| K₂O | 1.2 | 1.2 | 1.2 | 0 | 3.0 | 1.2 | 1.2 |
| ZrO₂ | 0 | 0 | 1.9 | 0 | 1.9 | 0 | 0 |
| CeO₂ | 0.8 | 0.8 | 0.8 | 0.8 | 0.8 | 0.8 | 0.5 |
| Fe₂O₃ | 0.04 | 0.04 | 0.04 | 0.04 | 0.04 | 0.04 | 0.04 |
| Sb₂O₃ | 0 | 0 | 0 | 0 | 0 | 0 | 0 |
| Ts | 720 | 718 | 730 | 722 | 726 | 724 | 720 |
| Sp | 508 | 501 | 513 | 511 | 515 | 504 | 504 |
| T2 | 1398 | 1412 | 1406 | 1420 | 1386 | 1409 | 1403 |
| α | 91 | 90 | 91 | 90 | 90 | 91 | 91 |
| T_{AV} | 91.7 | 91.8 | 91.4 | 91.7 | 92.0 | 92.2 | 91.9 |
| T₄₀₀ | 89.2 | 89.6 | 88.6 | 90.0 | 90.0 | 89.6 | 90.5 |
| T'₄₀₀ | 86.7 | 86.3 | 86.1 | 88.4 | 88.0 | 88.7 | 87.2 |
| Δ₄₀₀ | 2.5 | 3.3 | 2.5 | 1.6 | 2.0 | 0.9 | 3.3 |
| Weather resistance | 31 | 31 | 13 | 36 | - | - | - |

**[Table 2]**

| | Example 8 | Example 9 | Example 10 | Example 11 | Example 12 | Example 13 |
|---|---|---|---|---|---|---|
| SiO₂ | 64.3 | 64.7 | 65.1 | 66.9 | 65.6 | 67.5 |
| Al₂O₃ | 4.8 | 4.9 | 6.4 | 6.0 | 7.6 | 6.1 |
| B₂O₃ | 1.1 | 1.1 | 1.1 | 1.0 | 1.0 | 0.9 |
| MgO | 2.5 | 3.5 | 0 | 2.4 | 2.3 | 2.4 |
| CaO | 4.9 | 5.4 | 6.1 | 4.6 | 4.5 | 4.6 |
| SrO | 6.5 | 5.4 | 5.5 | 3.3 | 3.3 | 3.3 |
| BaO | 0 | 0 | 0 | 0 | 0 | 0 |
| Na₂O | 13.1 | 13.1 | 13.5 | 14.1 | 13.9 | 14.2 |
| K₂O | 1.2 | 1.2 | 1.5 | 1.1 | 1.2 | 1.0 |
| ZrO₂ | 1.0 | 0 | 0 | 0 | 0 | 0 |
| CeO₂ | 0.6 | 0.7 | 0.8 | 0.6 | 0.6 | 0 |
| Fe₂O₃ | 0.04 | 0.04 | 0.04 | 0.04 | 0.04 | 0.04 |
| Sb₂O₃ | 0 | 0 | 0 | 0 | 0 | 0.3 |
| Ts | 719 | 716 | 715 | 716 | 729 | 714 |
| Sp | 509 | 504 | 504 | 493 | 505 | 490 |
| T2 | 1397 | 1392 | 1443 | 1462 | 1493 | 1448 |
| α | 93 | 91 | 93 | 89 | 89 | 90 |
| T_{AV} | 91.6 | 91.7 | 91.6 | 91.8 | 91.7 | 91.8 |
| T₄₀₀ | 89.6 | 89.4 | 88.9 | 89.9 | 89.8 | 91.1 |
| T'₄₀₀ | 86.6 | 86.5 | 86.6 | 87.0 | 86.8 | 89.8 |
| Δ₄₀₀ | 3.0 | 2.9 | 2.3 | 2.9 | 3.0 | 1.3 |
| Weather Resistance | - | - | 33 | - | - | - |

**[Table 3]**

| | Example 14 | Example 15 | Example 16 | Example 17 |
|---|---|---|---|---|
| SiO₂ | 69.6 | 59.9 | 69.8 | 70.5 |
| Al₂O₃ | 1.9 | 8.0 | 2.5 | 3.7 |
| B₂O₃ | 1.0 | 0 | 0.9 | 0.9 |
| MgO | 3.2 | 3.2 | 3.1 | 2.7 |
| CaO | 6.1 | 6.7 | 6.2 | 5.1 |
| SrO | 0 | 3.7 | 0 | 0 |
| BaO | 0.3 | 0 | 0.4 | 2.0 |
| Na₂O | 16.4 | 2.3 | 15.0 | 12.3 |
| K₂O | 1.5 | 13.2 | 1.3 | 2.8 |
| ZrO₂ | 0 | 3.0 | 0 | 0 |
| CeO₂ | 0 | 0 | 0.8 | 0 |
| Fe₂O₃ | 0.04 | 0 | 0.04 | 0.02 |
| Sb₂O₃ | 0 | 0 | 0.3 | 0 |
| Ts | 694 | - | - | 715 |
| Sp | 484 | 610 | - | 481 |
| T2 | 1387 | 1594 | - | 1471 |
| α | 97 | 85 | 93 | 88 |
| T_{AV} | 91.9 | - | 91.8 | 92.0 |
| T₄₀₀ | 91.4 | - | 90.7 | 91.5 |
| T'₄₀₀ | 89.5 | - | 84.4 | - |
| Δ₄₀₀ | 1.9 | - | 6.3 | - |
| Weather Resistance | 892 | - | - | 238 |

While the invention has been described in detail and with reference to specific embodiments thereof, it will be apparent to one skilled in the art that various changes and modifications can be made therein without departing from the spirit and scope of the invention.
This application is based on Japanese Patent Application No. 2008-281614 filed on October 31, 2008 and Japanese Patent Application No. 2009-046148 filed on February 27, 2009, the contents of which are incorporated herein by reference.

### Industrial Applicability

According to the present invention, the glass tube of a solar cell, which has a double glass tube structure, can be made to satisfy the conditions that the annealing point or softening point is high in comparison with the soda lime glass-type tube glass employed for fluorescent tubes and the viscosity at high temperatures involving melting of glass is not so much raised as compared with the soda lime glass-type tube glass. Also, the transmittance of the glass tub on the long wavelength side e can be increased or the solarization resistance can be enhanced.

## Claims

1. A solar cell comprising a double tube composed of two glass tubes differing in the diameter and a photovoltaic conversion layer formed between the two glass tubes, the double tube being sealed at both ends of a part in which the photovoltaic conversion layer is formed,
wherein at least one of the two glass tubes is composed of a glass comprising, in mass% based on the oxides, from 60 to 70% of SiO₂, from 4 to 10% of Al₂O₃, from 0 to 3% of B₂O₃, from 0 to 4% of MgO, from 2 to 9% of CaO, from 1 to 10% of SrO, from 0 to 2% of BaO, from 10 to 16% of Na₂O, from 0 to 5% of K₂O, from 0 to 2% of ZrO₂ and from 0 to 2% of CeO₂.

2. The solar cell according to claim 1, wherein out of the two glass tubes of the double tube, the glass tube having a larger diameter is composed of the glass, and the glass comprises 0.2% or more of CeO₂.

3. The solar cell according to claim 1 or 2, wherein a content of Fe₂O₃ in the glass is 0.06% by outer percentage or less based on the total of other components (exclusive of Sb₂O₃ in the case where Sb₂O₃ is contained).

4. The solar cell according to claim 1, 2 or 3, wherein the glass comprises CeO₂ and does not substantially comprise Sb₂O₃.

5. The solar cell according to claim 1 or 3, wherein the glass comprises Sb₂O₃ and does not substantially comprise CeO₂.

6. The solar cell according to any one of claims 1 to 5, wherein a softening point of the glass is 705°C or more.

7. The solar cell according to any one of claims 1 to 6, wherein a strain point of the glass is 490°C or more.

8. The solar cell according to any one of claims 1 to 7, wherein a temperature at which a viscosity of the glass is 10² dPa·s is 1,550°C or less.

9. The solar cell according to any one of claims 1 to 8, wherein an average linear expansion coefficient of the glass at 50 to 300°C is from 70×10⁻⁷ to 110× 10⁻⁷/°C.

10. The solar cell according to any one of claims 1 to 9, wherein an average transmittance of the glass at a wavelength of 450 to 1,000 nm is 90% or more in terms of thickness of 1 mm.

11. The solar cell according to any one of claims 1 to 10, wherein when a glass plate which has a thickness of 1 mm and is composed of the glass is irradiated with light of a high-pressure mercury lamp of 400 W for 300 hours from a distance of 15 cm, a decrease in the transmittance at a wavelength of 400 nm is 4% or less.

12. The solar cell according to any one of claims 1 to 11, wherein when the glass is held in a water vapor atmosphere at 120°C under 0.2 MPa for 20 hours, an amount of an alkali metal element deposited on a surface of the glass is 180 nmol/cm² or less.

13. A glass tube for a solar cell, which is used as at least one of two glass tubes of a solar cell comprising a double tube composed of two glass tubes differing in the diameter and a photovoltaic conversion layer formed between the two glass tubes, the double tube being sealed at both ends of a part in which the photovoltaic conversion layer is formed, and which is composed of a glass comprising, in mass% based on the oxides, from 60 to 70% of SiO₂, from 4 to 10% of Al₂O₃, from 0 to 3% of B₂O_{3,} from 0 to 4% of MgO, from 2 to 9% of CaO, from 1 to 10% of SrO, from 0 to 2% of BaO, from 10 to 16% of Na₂O, from 0 to 5% of K₂O, from 0 to 2% of ZrO₂ and from 0 to 2% of CeO₂.

14. The glass tube for a solar cell according to claim 13, wherein when the glass is held in a water vapor atmosphere at 120°C under 0.2 MPa for 20 hours, an amount of an alkali metal element deposited on a surface of the glass is 180 nmol/cm² or less.
